# EUROPEAN PATENT SPECIFICATION

(11) **EP 3 557 618 B1**
(45) Date of publication and mention of the grant of the patent: **26.10.2022**
(21) Application number: 19169096.5
(22) Date of filing: 12.04.2019
(51) Int. Cl.: H01L 25/075, H01L 25/16

(54) **ELECTRONIC DEVICE**
ELEKTRONISCHE VORRICHTUNG
DISPOSITIF ÉLECTRONIQUE

(30) Priority: 19.04.2018 US 201862659794 P; 10.10.2018 CN 201811178409
(43) Date of publication of application: 23.10.2019
(73) Proprietor: InnoLux Corporation, Miao-Li County 350 (TW)
(72) Inventor: FAN, Chun-Chin, Miao-Li County 350 (TW); LIN, Ming-Chang, Miao-Li County 350 (TW); CHEN, Yun-Sheng, Miao-Li County 350 (TW)
(74) Representative: 2K Patentanwälte Blasberg Kewitz & Reichel

(56) References cited:
- US-A1- 2015 340 346
- US-A1- 2016 093 644
- US-A1- 2017 062 397
- US-A1- 2017 133 357
- US-A1- 2017 309 651
- US-A1- 2017 358 503
- US-A1- 2017 358 624

## Description

### CROSS REFERENCE TO RELATED APPLICATIONS

This application claims priority of provisional application of U.S. Patent Application No. 62/659,794 filed on April 19, 2018, and China Patent Application No. 201811178409.7 filed on October 10, 2018.

### BACKGROUND

### Technical Field

The present disclosure relates to electronic devices, and in particular to display devices.

### Description of the Related Art

As digital technology develops, electronic devices are becoming more widely used in our society. For example, electronic devices have been applied in modern information and communication devices such as televisions, notebooks, computers, and mobile phones (e.g., smartphones). In addition, each generation of electronic devices has been developed to be thinner, lighter, smaller, and more fashionable than the previous generation.

Among the various types of electronic devices available, light-emitting diode (LED) display devices become more and more popular, since they have advantages such as high efficiency and a long life span.

However, existing electronic devices are not satisfactory in all respects.

US 2017/309651 A1 discloses a display device including a substrate comprising a display area to display an image and a non-display area provided on at least one side of the display area, a plurality of pixels disposed on the substrate and provided in an area corresponding to the display area, a first insulating layer having an opening in a first area of the non-display area, a second insulating layer provided in the first area, first lines provided on the substrate and connected to the plurality of pixels, and second lines provided on the first and second insulating layers, and connected to the first lines. An area in which the first lines overlap with the second lines is spaced apart from an edge of the second insulating layer when viewed in a plan view.

US 2015/340346 A1 discloses a structure of a semiconductor array comprising multiple semiconductor units, an isolation layer and a decomposed or buffer unit. Multiple semiconductor units combined the semiconductor array. The isolation layer coated each semiconductor unit. The decomposed or buffer unit coated the isolation layer and filled between each semiconductor unit to enhance structure of the semiconductor units. Wherein, the isolation layer protected by edge of the semiconductor units and the decomposed or buffer unit.

US 2017/358624 A1 discloses a display apparatus including a light emitting diode part including a plurality of regularly arranged light emitting diodes, and a TFT panel part configured to drive the light emitting diode part. The light emitting diode part includes a transparent electrode, the light emitting diodes regularly disposed on a first surface of the transparent electrode and electrically connected to the transparent electrode, a plurality of first reflective electrodes disposed at sides of the light emitting diodes, surrounding the light emitting diodes, and electrically connected to the transparent electrode, and a plurality of second reflective electrodes electrically connected to the light emitting diodes, respectively, and reflecting light emitted from the light emitting diodes.

US 2017/133357 A1 discloses a display device including an array substrate, an opposite substrate, a plurality of micro light-emitting diodes and a plurality of bank structures. The opposite substrate is disposed opposite to the array substrate. The micro light-emitting diodes are arranged in an array on the array substrate, wherein the micro light-emitting diodes are electrically connected to the array substrate. The bank structures are located between the array substrate and the opposite substrate, wherein the bank structures form a plurality of accommodating regions, and one of the micro light-emitting diodes is located in one of the accommodating regions. A height of the bank structures is more than or equal to a height of the micro light-emitting diodes.

US 2017/062397 A1 discloses a display apparatus comprising a first electrode, and a protruding portion which protrudes from an upper surface of the first electrode. The LED includes a p-n diode, a first contact electrode disposed at a side of the p-n diode, and an insulating member surrounding the first contact electrode and in which an opening is defined which exposes a surface of the first contact electrode. The protruding portion of the first electrode member extends into the opening of the light-emitting diode and is in contact with the exposed surface of the first contact electrode.

US 2017/358503 A1 discloses a pixel device comprising a pixel electrode which is disposed on the insulating layer and is electrically connected to the second transistor. The pixel electrode is at least partially overlapped with the conductive connection portion. A light-emitting element is disposed on the pixel electrode. The conductive connection portion and the pixel electrode form a capacitor. The capacitor has an equivalent permittivity and a thickness. The ratio of the equivalent permittivity to the thickness is in a range from 0.4^{∗}(1E+5)F/m̂2 to 296.48^{∗}(1E+5)F/m̂2.

US 2016/093644 A1 discloses a flexible display having a plurality of innovations configured to allow bending of a portion or portions to reduce apparent border size and/or utilize the side surface of an assembled flexible display.

### BRIEF SUMMARY

Some embodiments of the present disclosure provide an electronic device. The electronic device includes a substrate comprising a bendable portion and a non-bending portion adjacent to the bendable portion, a plurality of thin-film transistors disposed on the non-bending portion of the substrate, a first insulating layer disposed on the plurality of thin-film transistors, and a plurality of light-emitting units. One of the plurality of light-emitting units is electrically connected to at least one of the thin-film transistors. The electronic device further includes a conductive line disposed on the bendable portion, wherein a thickness of the first insulating layer on the non-bending portion is less than a thickness of the first insulating layer on the bendable portion and the conductive line has an undulating edge or at least one opening.

A detailed description is given in the following embodiments with reference to the accompanying drawings.

### BRIEF DESCRIPTION OF THE DRAWINGS

The disclosure can be more fully understood from the following detailed description when read with the accompanying figures. It is worth noting that, in practice of the industry, various features are not drawn in real scale. In fact, the dimensions of the various features may be arbitrarily increased or reduced for easy and clear description.
FIG. 1 is a partial cross-sectional view of the electronic device 1 according to some embodiments not covered by the claims.
FIG. 2 is a partial cross-sectional view of the electronic device 10 according to some embodiments of the present disclosure.
FIG. 3 is a partial top view of the conductive line 134a of the conductive layer 134 according to some embodiments of the present disclosure.
FIG. 4 is a partial cross-sectional view of the electronic device 20 according to some embodiments of the present disclosure.
FIG. 5 is a partial cross-sectional view of the light-emitting unit 150 according to some embodiments of the present disclosure.
FIG. 6 is a partial top view of the light-emitting unit 150 according to some embodiments of the present disclosure.
FIG. 7 is a partial cross-sectional view of the light-emitting unit 150 according to some embodiments of the present disclosure.
FIG. 8 is a partial cross-sectional view of the light-emitting unit 150 according to some embodiments of the present disclosure.
FIG. 9 is a partial cross-sectional view of the light-emitting unit 150 according to some embodiments of the present disclosure.
FIG. 10 is a partial top view of the light-emitting unit 150 according to some embodiments of the present disclosure.

### DETAILED DESCRIPTION

The following disclosure provides many different embodiments, or examples, for implementing different features of the subject matter provided. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact.

In addition, the present disclosure may repeatedly use the same reference numerals and/or letters in the various embodiments. This repetition is for simplicity and clarity and does not in itself dictate a relationship between the various embodiments and/or configurations discussed.

Some embodiments of the present disclosure will be described below. Additional operations may be provided before, during, and/or after the steps described in these embodiments. Some of the steps described may be replaced or omitted in different embodiments. In addition, although some embodiments of the present disclosure will be discussed in the following paragraphs with several steps in a specific order, these steps may be performed in another reasonable order.

Some embodiments of the present disclosure provide some electronic devices (e.g., display devices). The electronic devices of the present disclosure have a bendable (or flexible) portion, and an insulating layer with good ductility may be included in the bendable portion. Therefore, problems such as cracking are less likely to occur when bending such electronic devices. In addition, in some embodiments, a substantially planar insulating layer is disposed between the light-emitting unit and the substrate of the electronic device, so that the conductive pads configured to connect the light-emitting unit can be located at substantially the same level. Therefore, the problem of the poor bonding between the light-emitting unit and the conductive pads can be alleviated, and thus the yield of the electronic device can be improved.

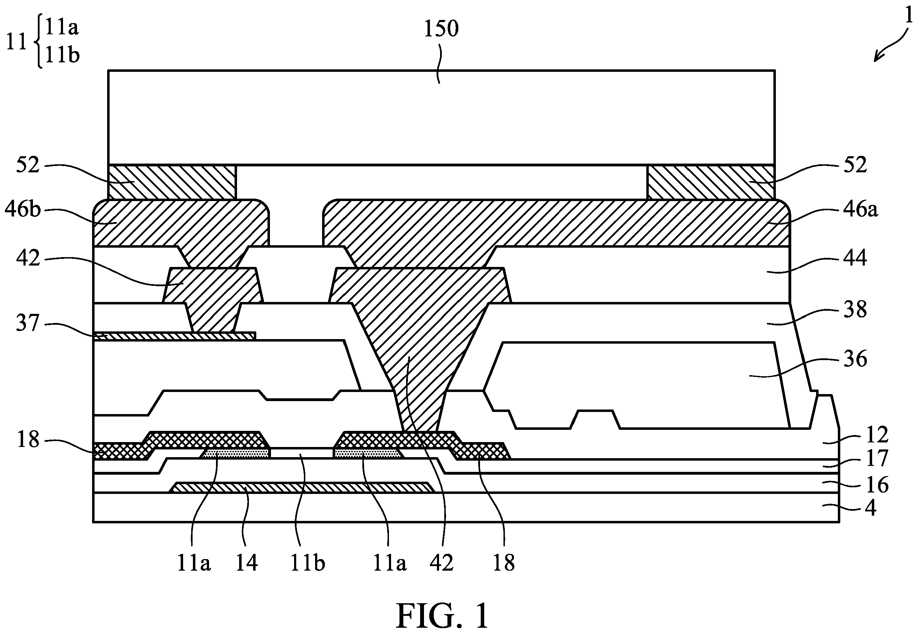

FIG. 1 illustrates a partial cross-sectional view of an electronic device (e.g., a display device) 1 of embodiments not covered by the claims. The electronic device 1 may include a substrate 4, as shown in FIG. 1. For example, the substrate 4 may include a material with low ductility (e.g., glass), or a material with high ductility (e.g., polyimide (PI), or polyethylene terephthalate (PET)), or another applicable material. However, the present disclosure is not limited thereto.

Still referring to FIG. 1, in some embodiments not covered by the claims, the electronic device 1 may include a gate layer 14 disposed on the substrate 4. In some embodiments, the gate layer 14 may include scan lines. In some embodiments, the gate layer 14 may include a metal, another applicable conductive material, or a combination thereof. The gate layer 14 may be formed by using a chemical vapor deposition process, a physical vapor deposition process, another applicable process, or a combination thereof, but the present disclosure is not limited thereto.

Still referring to FIG. 1, in some embodiments not covered by the claims, the electronic device 1 may include a gate insulating layer 16 disposed on the gate layer 14. In some embodiments not covered by the claims, the gate insulating layer 16 may include silicon oxide, silicon nitride, silicon oxynitride, other applicable materials, or a combination thereof. In some embodiments not covered by the claims, the gate insulating layer 16 may include a high-k dielectric material. In some embodiments not covered by the claims, the gate insulating layer 16 may be formed by using a chemical vapor deposition process, a spin-on coating process, an atomic layer deposition process, another applicable process, or a combination thereof.

Still referring to FIG. 1, in some embodiments not covered by the claims, the electronic device 1 may include an active layer 11 disposed on the gate insulating layer 16. In some embodiments not covered by the claims, the active layer 11 may include poly-silicon, and the poly-silicon may be formed by using a low temperature poly-silicon process, but the present disclosure is not limited thereto. In some other embodiments not covered by the claims, the active layer 11 may include amorphous silicon, indium gallium zinc oxide (IGZO), other applicable materials, or a combination thereof. In some embodiments not covered by the claims, the active layer 11 may include source/drain regions 11a and a channel region 11b. In some embodiments not covered by the claims, the electronic device 1 may include an insulating layer 17 disposed on the gate insulating layer 16.

In some embodiments not covered by the claims, as shown in FIG. 1, the electronic device 1 may include conductive elements 18. In some embodiments not covered by the claims, the conductive element 18 is electrically connected to the source/drain regions 11a. For example, the conductive element 18 may include a metal, a transparent conductive material, another applicable conductive material, or a combination thereof. The gate layer 14, the gate insulating layer 16, the active layer 11, and the conductive elements 18 can be together to form a thin-film transistor. FIG. 1 illustrates only one thin-film transistor of the electronic device 1. However, in fact, the electronic device 1 can include a plurality of thin-film transistors.

Still referring to FIG. 1, in some embodiments not covered by the claims, the electronic device 1 may include a passivation layer 12 disposed on the conductive elements 18. For example, the passivation layer 12 may include silicon nitride, silicon oxide, aluminum oxide, another applicable material, or a combination thereof, and the passivation layer 12 may be formed by using a chemical vapor deposition process, a thermal oxidation process, another applicable process, or a combination thereof, but the present disclosure is not limited thereto.

Still referring to FIG. 1, in some embodiments not covered by the claims, the electronic device 1 may include an insulating layer 36 disposed on the passivation layer 12. In some embodiments not covered by the claims, the insulating layer 36 includes an organic photoresist material and thus has a good ductility. In some embodiments not covered by the claims, an organic photoresist material with good fluidity is coated on the substrate 4 by a spin-on coating process or a slit coating process, then an applicable patterning process (e.g., a lithography process, an etching process, another applicable process, or a combination thereof) is performed to form the insulating layer 36. In some embodiments not covered by the claims, the insulating layer 36 may be a silicon oxide layer, a silicon nitride layer, or another applicable insulating layer formed by a chemical vapor deposition process or another applicable process.

Still referring to FIG. 1, in some embodiments not covered by the claims,embodiments not covered by the claims, the electronic device 1 may include an insulating layer 38 disposed on the insulating layer 36. The materials and forming methods of the insulating layer 38 may be the same as or similar to those of the insulating layer 36. In the interest of simplicity and clarity, those details will not be discussed again.

In some embodiments not covered by the claims, as shown in FIG. 1, the electronic device 1 may include a conductive layer 37 disposed between the insulating layer 36 and the insulating layer 38. In some embodiments not covered by the claims, the conductive layer 37 may include a common electrode. For example, the conductive layer 37 may include a metal oxide, a metal, or another applicable conductive material.

In some embodiments not covered by the claims, as shown in FIG. 1, the electronic device 1 may include a conductive layer 42 disposed on the insulating layer 38. In some embodiments not covered by the claims, the conductive layer 42 may include conductive lines, other applicable conductive elements, or a combination thereof. For example, the conductive layer 42 may include a metal or another applicable conductive material. For example, the process for forming the conductive layer 42 may include a physical vapor deposition process, a lithography process, an etching process, another applicable process, or a combination thereof.

Still referring to FIG. 1, in some embodiments not covered by the claims, the electronic device 1 may include an insulating layer 44 disposed on the insulating layer 38. In some embodiments not covered by the claims, the insulating layer 44 may have a substantially planar top surface. In some embodiments not covered by the claims, the top surface of the insulating layer 44 may be substantially parallel to the top surface of the substrate 4. However, the present disclosure is not limited thereto. In some embodiments not covered by the claims, the top surface of the insulating layer 44 is substantially planar, so that the conductive pads (e.g., conductive pads 46a and 46b which will be discussed in the following paragraphs) configured to connect the light-emitting unit can be located at substantially the same level, thus alleviating the problem of the poor bonding between the light-emitting unit and the conductive pads and improving the yield of the electronic device.

In some embodiments not covered by the claims, the insulating layer 44 may include silicon nitride, silicon oxide, another applicable material, or a combination thereof. In some embodiments not covered by the claims, the insulating layer 44 may include a polymer material. In some embodiments not covered by the claims, the insulating layer 44 may include an organic photoresist material. In some embodiments, the insulating layer 44 may be formed by using a chemical vapor deposition process, a thermal oxidation process, another applicable process, or a combination thereof. In some embodiments not covered by the claims, the process for forming the insulating layer 44 may include a spin-on coating process, a curing process, other applicable processes, or a combination thereof.

Still referring to FIG. 1, in some embodiments not covered by the claims, the electronic device 1 may include a conductive pad 46a and a conductive pad 46b. In some embodiments not covered by the claims, at least a portion of the insulating layer 44 is located between the conductive pads (e.g., the conductive pad 46a and the conductive pad 46b). In some embodiments not covered by the claims, the top surface of the conductive pad 46a and the top surface of the conductive pad 46b are substantially at the same level. In some embodiments not covered by the claims, the top surface of the conductive pad 46a and the top surface of the conductive pad 46b are coplanar.

In some embodiments not covered by the claims, the conductive pad 46a and the conductive pad 46b may extend into the insulating layer 44 from the top surface of the insulating layer 44. In some embodiments, the conductive pad 46a and the conductive pad 46b may include a metal, another conductive material, or a combination thereof.

In some embodiments not covered by the claims, a patterning process (e.g., a lithography process, an etching process, another applicable process, or a combination thereof) may be performed to form appropriate openings in the insulating layer 44, then a physical vapor deposition process, an electroplating process, an electroless plating process, another applicable process, or a combination thereof may be applied to deposit a conductive material in the openings and on the top surface of the insulating layer 44 to form the conductive pad 46a and the conductive pad 46b.

Still referring to FIG. 1, in some embodiments not covered by the claims, the electronic device 1 may include a light-emitting unit 150 connected to the conductive pad 46a and the conductive pad 46b. In some embodiments not covered by the claims, the electronic device 1 has a plurality of light-emitting units, but FIG. 1 illustrates only one light-emitting unit for simplicity and clarity. In some embodiments not covered by the claims, the light-emitting unit 150 may include a light-emitting diode, an organic light-emitting diode, a micro light-emitting diode (Micro-LED), a quantum-dot light-emitting diode (QLED or QD-LED), a mini light-emitting diode (Mini-LED), other applicable light-emitting units, or a combination thereof. For example, the light-emitting unit 150 may be electrically connected to the conductive pad 46a and the conductive pad 46b through a conductive medium 52. For example, the conductive medium 52 may include tin, tin alloy, conductive glue (or conductive paste), another applicable material, or a combination thereof. In some embodiments, the process for bonding the light-emitting unit 150 to the conductive pad 46a and the conductive pad 46b may include a soldering process (e.g., surface-mount technology (SMT)), but the present disclosure is not limited thereto. In some embodiments not covered by the claims, the conductive medium 52 overlaps the conductive pad 46a or the conductive pad 46b in the top view, but the present disclosure is not limited thereto.

In some embodiments not covered by the claims, the light-emitting unit 150 may be electrically connected to the conductive element 18 through the conductive medium 52, the conductive pad 46a or 46b, and the conductive layer 42. The thin-film transistor discussed above can control the light-emitting performance of the light-emitting unit 150. In some embodiments not covered by the claims, the light-emitting unit 150 is electrically connected to a plurality of thin-film transistors

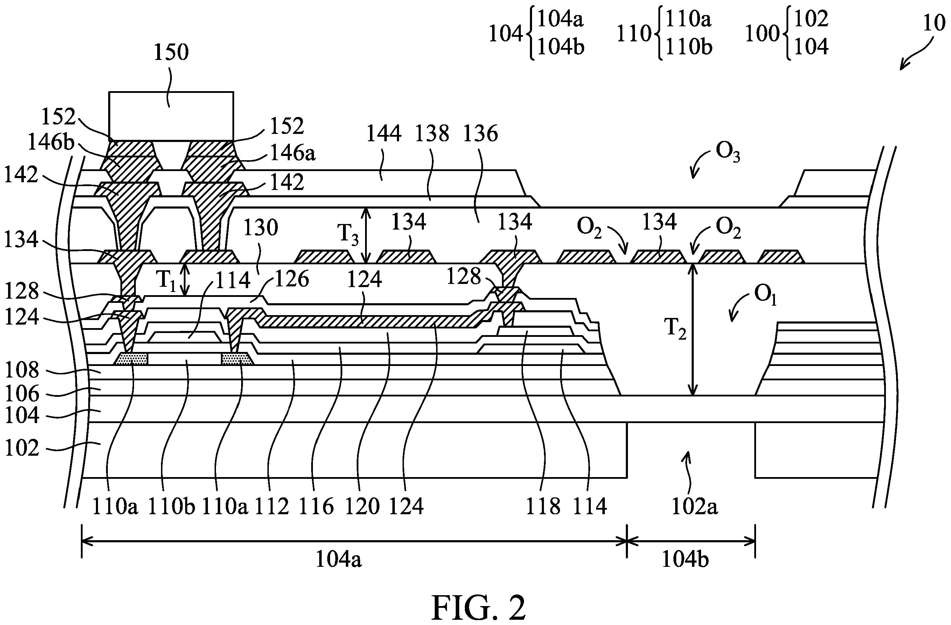

FIG. 2 illustrates a partial cross-sectional view of an electronic device (e.g., a display device) 10 of embodiments of the present disclosure. In some embodiments, the electronic device 10 may include a composite substrate 100, as shown in FIG. 2. In some embodiments, the composite substrate 100 may include a transparent substrate, but the present disclosure is not limited thereto. In some embodiments, the composite substrate 100 may include a sub-layer 102, a substrate 104, and thin-film transistors disposed on the substrate 104. For example, the thin-film transistors may include an active layer 110, a gate insulating layer 112 and a gate layer 114 which will be discussed in the following paragraphs. In some embodiments, the composite substrate 100 includes the substrate 104 and the thin-film transistors disposed on the substrate 104, but not include the sub-layer 102.

As shown in FIG. 2, the substrate 104 includes a non-bending portion 104a and a bendable (or flexible) portion 104b. The bendable portion 104b is adjacent to the non-bending portion 104a. Specifically, in these embodiments, the bendable portion 104b of the substrate 104, and the layers and elements formed on the bendable portion 104b of the electronic device 10 may be bent.

In the invention, thin-film transistors are disposed on and/or in the non-bending portion 104a of the substrate 104, and conductive lines are disposed on and/or in the bendable portion 104b of the substrate 104. However, the present disclosure is not limited thereto.

In some embodiments, the substrate 104 is a flexible layer. In some embodiments, the ductility of the substrate 104 is greater than that of the sub-layer 102. In some embodiments, the strength (e.g., the tensile strength) of the sub-layer 102 is greater than that of the substrate 104.

In some embodiments, the sub-layer 102 and the substrate 104 include different materials. For example, the sub-layer 102 may include glass, and the substrate 104 may include polyimide or polyethylene terephthalate, but the present disclosure is not limited thereto. In some other embodiments, the sub-layer 102 and the substrate 104 may include any other applicable materials.

In some embodiments, the substrate 104 may be formed on the sub-layer 102 by using a spin-on coating process, a rolling process, a vacuum laminating process, a chemical vapor deposition process, another applicable process, or a combination thereof, but the present disclosure is not limited thereto.

In some embodiments, as shown in FIG. 2, one or more openings (or recesses) 102a may be formed under the bendable portion 104b of the substrate 104. Therefore, the problem of cracking due to the low ductility of the sub-layer 102 may be alleviated when the composite substrate 100 is bent.

In some embodiments, as shown in FIG. 2, the opening (or recess) 102a may expose the substrate 104 of the composite substrate 100, but the present disclosure is not limited thereto. In some other embodiments, the opening (or recess) 102a may not expose the substrate 104 of the composite substrate 100.

Still referring to FIG. 2, in some embodiments, the electronic device 10 may include an insulating layer 106 disposed on the substrate 104. In some embodiments, the insulating layer 106 may block the moisture and the oxygen to reduce the oxidation of the layers disposed on the insulating layer 106. For example, the insulating layer 106 may include silicon nitride, silicon oxide, aluminum oxide, another applicable material, or a combination thereof, and the insulating layer 106 may be formed by using a chemical vapor deposition process, a thermal oxidation process, another applicable process, or a combination thereof, but the present disclosure is not limited thereto.

In some embodiments, after forming the insulating layer 106, a patterning process may be performed on the insulating layer 106 to form a portion of an opening O₁ in the insulating layer 106. In some embodiments, the opening O₁ may be located on and/or in the bendable portion 104b of the substrate 104. In some embodiments, the opening O₁ may expose the top surface of the substrate 104. In some embodiments, in the top view, the opening O₁ may be substantially oval, square, rectangular, round, oblong, triangular, polygonal, irregular shape, another applicable shape, or a combination thereof.

In some embodiments, the patterning process may include a lithography process, an etching process, another applicable process, or a combination thereof. For example, the lithography process may include photoresist coating (e.g., spin-on coating), soft baking, mask aligning, exposure, post-exposure, developing photoresist, rising, drying (e.g., hard baking), another applicable process, or a combination thereof. For example, the etching process may include a dry etching process (e.g., a plasma etching process), a wet etching process, another applicable process, or a combination thereof.

Still referring to FIG. 2, in some embodiments, the electronic device 10 may include an insulating layer 108 disposed on the insulating layer 106. The insulating layer 108 may include silicon nitride, silicon oxide, aluminum oxide, another applicable material, or a combination thereof, and the insulating layer 108 may be formed by using a chemical vapor deposition process, a thermal oxidation process, another applicable process, or a combination thereof, but the present disclosure is not limited thereto. In some embodiments, the insulating layer 106 and the insulating layer 108 may include the same material, but the present disclosure is not limited thereto. In some other embodiments, the insulating layer 106 and the insulating layer 108 may include different materials (e.g., the insulating layer 106 includes silicon oxide and the insulating layer 108 includes silicon nitride).

In some embodiments, after forming the insulating layer 108, a patterning process may be performed on the insulating layer 108 to form a portion of the opening O₁ in the insulating layer 108. In some embodiments, the portion of the opening O₁ in the insulating layer 108 is in communication with the portion of the opening O₁ in the insulating layer 106. In some embodiments, the patterning process may include a lithography process, an etching process, another applicable process, or a combination thereof.

Still referring to FIG. 2, in some embodiments, the electronic device 10 may include an active layer 110 disposed on the insulating layer 108. In some embodiments, the active layer 110 may include poly-silicon, and the poly-silicon may be formed by using a low temperature poly-silicon (LTPS) process, but the present disclosure is not limited thereto. In some other embodiments, the active layer 110 may include amorphous silicon (a-Si), indium gallium zinc oxide (IGZO), other applicable materials, or a combination thereof.

In some embodiments, the active layer 110 may include source/drain regions 110a and a channel region 110b of a thin-film transistor. In some embodiments, the source/drain regions 110a are the source/drain regions of a n-type thin-film transistor, and therefore the source/drain regions 110a may be doped with phosphorus, arsenic, antimony, another applicable n-type dopant, or a combination thereof. In some other embodiments, the source/drain regions 110a are the source/drain regions of a p-type thin-film transistor, and therefore the source/drain regions 110a may be doped with boron, indium, another applicable p-type dopant, or a combination thereof. In some embodiments, an ion implantation process may be used to implant appropriate dopants into the active layer 110 so as to form the source/drain regions 110a of the thin-film transistor.

Still referring to FIG. 2, in some embodiments, the electronic device 10 may include a gate insulating layer 112 disposed on the active layer 110. In some embodiments, the gate insulating layer 112 may include silicon oxide, silicon nitride, silicon oxynitride, other applicable materials, or a combination thereof. In some embodiments, the gate insulating layer 112 may include a high-k dielectric material (e.g., LaO, AlO, ZrO, TiO, Ta₂O₅, Y₂O₃, SrTiO₃ (STO) , BaTiO₃ (BTO) , BaZrO, HfO₂, HfO₃, HfZrO, HfLaO, HfSiO, HfSiON, LaSiO, AlSiO, HfTaO, HfTiO, HfTaTiO, HfAlON, (Ba,Sr) TiO₃ (BST) , Al₂O₃, another applicable material, or a combination thereof). The gate insulating layer 112 may be formed by using a chemical vapor deposition process, a spin-on coating process, an atomic layer deposition process, another applicable process, or a combination thereof. For example, a chemical vapor deposition process may include a low pressure chemical vapor deposition (LPCVD) process, a low temperature chemical vapor deposition (LTCVD) process, a rapid thermal chemical vapor deposition (RTCVD) process, a plasma enhanced chemical vapor deposition (PECVD) process, another applicable chemical vapor deposition process, or a combination thereof.

In some embodiments, after forming the gate insulating layer 112, a patterning process may be performed on the gate insulating layer 112 to form a portion of the opening O₁ in the gate insulating layer 112. In some embodiments, the portion of the opening O₁ in the gate insulating layer 112 is in communication with the portion of the opening O₁ in the insulating layer 108. In some embodiments, the patterning process may include a lithography process, an etching process, another applicable process, or a combination thereof.

Still referring to FIG. 2, in some embodiments, the electronic device 10 may include a gate layer 114 disposed on the gate insulating layer 112. In some embodiments, the active layer 110, the gate insulating layer 112 and the gate layer 114 can be together to form a thin-film transistor. In some embodiments, the current signal transmitted to the light-emitting unit (e.g., light-emitting unit 150 which will be discussed in the following paragraphs) of the electronic device 10 can be controlled through the thin-film transistor discussed above, such that the light-emitting performance of the light-emitting unit of the electronic device 10 can be controlled. In some embodiments, the gate layer 114 may include or electrically connect to the scan lines of the electronic device 10.

In some embodiments, the gate layer 114 may include a metal, a metal nitride, a metal oxide, another applicable conductive material, or a combination thereof. For example, the metal may include copper, molybdenum, tungsten, titanium, tantalum, platinum, hafnium, another applicable metal, or a combination thereof. For example, the metal nitride may include molybdenum nitride, tungsten nitride, titanium nitride, tantalum nitride, another applicable metal nitride, or a combination thereof. For example, the metal oxide may include ruthenium oxide, indium tin oxide, another applicable metal oxide, or a combination thereof. The gate layer 114 may be formed by using a chemical vapor deposition process, a physical vapor deposition process (e.g., a sputtering process or an evaporation process), another applicable process, or a combination thereof, but the present disclosure is not limited thereto.

Still referring to FIG. 2, in some embodiments, the electronic device 10 may include an insulating layer 116 disposed on the gate layer 114. In some embodiments, the insulating layer 116 may serve as the insulating layer of a metal-insulator-metal (MIM) capacitor structure.

For example, the insulating layer 116 may include silicon nitride, silicon oxide, aluminum oxide, another applicable material, or a combination thereof, and may be formed by using a chemical vapor deposition process, a thermal oxidation process, another applicable process, or a combination thereof, but the present disclosure is not limited thereto.

In some embodiments, after forming the insulating layer 116, a patterning process may be performed on the insulating layer 116 to form a portion of the opening O₁ in the insulating layer 116. In some embodiments, the portion of the opening O₁ in the insulating layer 116 is in communication with the portion of the opening O₁ in the gate insulating layer 112. In some embodiments, the patterning process may include a lithography process, an etching process, another applicable process, or a combination thereof.

Still referring to FIG. 2, in some embodiments, the electronic device 10 may include a metal layer 118 disposed on the insulating layer 116. In some embodiments, the gate layer 114, the insulating layer 116 and the metal layer 118 may be together to form a metal-insulator-metal capacitor structure. The materials and forming methods of the metal layer 118 may be the same as or similar to those of the gate layer 114. In the interest of simplicity and clarity, the details will not be discussed again.

Still referring to FIG. 2, in some embodiments, the electronic device 10 may include a dielectric layer 120 disposed on the insulating layer 116 and the metal layer 118. In some embodiments, the dielectric layer 120 may include silicon oxide, silicon nitride, another applicable material, or a combination thereof, and may be formed by using a chemical vapor deposition process, a thermal oxidation process, another applicable process, or a combination thereof, but the present disclosure is not limited thereto.

In some embodiments, after forming the dielectric layer 120, a patterning process may be performed on the dielectric layer 120 to form a portion of the opening O₁ in the dielectric layer 120. In some embodiments, the portion of the opening O₁ in the dielectric layer 120 is in communication with the portion of the opening O₁ in the insulating layer 116. In some embodiments, the patterning process may include a lithography process, an etching process, another applicable process, or a combination thereof.

Still referring to FIG. 2, in some embodiments, the electronic device 10 may include a conductive layer 124 disposed on the dielectric layer 120. In some embodiments, the conductive layer 124 may include or electrically connect to the data lines of the electronic device 10.

In some embodiments, the electronic device 10 may include one or more conductive vias penetrating the dielectric layer 120, the insulating layer 116 and/or the gate insulating layer 112, and the conductive layer 124 may be electrically connected to the active layer 110 through the conductive via(s). In some embodiments, the conductive layer 124 may be in direct contact with the source/drain regions 110a of the active layer 110. In some embodiments, the metal layer 118 may be electrically connected to the active layer 110 through the conductive layer 124. In some embodiments, the conductive layer 124 may include copper, molybdenum, tungsten, titanium, aluminum, tantalum, platinum, hafnium, another applicable conductive material, or alloys thereof.

In some embodiments, a patterning process (e.g., a lithography process, an etching process, another applicable process, or a combination thereof) may be utilized to form one or more appropriate openings in the dielectric layer 120, the insulating layer 116 and/or the gate insulating layer 112, and then the one or more openings may be filled with a conductive material to form the conductive layer 124 in the one or more openings by using a physical vapor deposition process (e.g., a sputtering process or an evaporation process), an electroplating process, another applicable process, or a combination thereof.

In some embodiments, a physical vapor deposition process (e.g., a sputtering process or an evaporation process), an electroplating process, another applicable process, or a combination thereof may be used to form a conductive blanket layer on the dielectric layer 120 and the conductive layer 124 in the openings, and then a patterning process (e.g., a lithography process, an etching process, another applicable process, or a combination thereof) may be performed on the conductive blanket layer to form the patterned conductive layer 124.

Still referring to FIG. 2, in some embodiments, the electronic device 10 may include a passivation layer 126 disposed on the conductive layer 124 and the dielectric layer 120. For example, the passivation layer 126 may include silicon nitride, silicon oxide, aluminum oxide, other applicable materials, or a combination thereof, and the passivation layer 126 may be formed by using a chemical vapor deposition process, a thermal oxidation process, another applicable process, or a combination thereof, but the present disclosure is not limited thereto.

In some embodiments, after forming the passivation layer 126, a patterning process may be performed on the passivation layer 126 to form a portion of the opening O₁ in the passivation layer 126. In some embodiments, the portion of the opening O₁ in the passivation layer 126 is in communication with the portion of the opening O₁ in the dielectric layer 120. In some embodiments, the patterning process may include a lithography process, an etching process, another applicable process, or a combination thereof.

Still referring to FIG. 2, in some embodiments, the electronic device 10 may include one or more bridging elements 128 disposed on the passivation layer 126 and penetrating the passivation layer 126. In some embodiments, the bridging element 128 and the conductive layer 124 may include different materials, but the present disclosure is not limited thereto.

In some embodiments, the bridging element 128 may include indium tin oxide (ITO), tin oxide (SnO), indium zinc oxide (IZO), indium gallium zinc oxide (IGZO), indium tin zinc oxide (ITZO), antimony tin oxide (ATO), antimony zinc oxide (AZO), another applicable transparent conductive material, or a combination thereof. In some other embodiments, the bridging element 128 may include copper, molybdenum, tungsten, titanium, aluminum, tantalum, platinum, hafnium, another applicable metal, or a combination thereof, but the present disclosure is not limited thereto.

In some embodiments, a patterning process (e.g., a lithography process, an etching process, another applicable process, or a combination thereof) may be utilized to form one or more appropriate openings in the passivation layer 126, and then a physical vapor deposition process (e.g., a sputtering process or an evaporation process), an atomic layer deposition process, another applicable process, or a combination thereof may be utilized to fill the one or more openings with an appropriate conductive material and to form a conductive blanket layer on the passivation layer 126, and then a patterning process (e.g., a lithography process, an etching process, another applicable process, or a combination thereof) may be performed on the conductive blanket layer to form the bridging element 128.

Still referring to FIG. 2, in the invention, the electronic device 10 includes an insulating layer 130 disposed on the passivation layer 126 and the bendable portion 104b. In some embodiments, the insulating layer 130 may fill the opening O₁. In some embodiments, the ductility of the insulating layer 130 including an organic photoresist material is better than the ductility of the insulating layer 106, the insulting layer 108, the gate insulating layer 112, the insulating layer 116, the dielectric layer 120 and/or the passivation layer 126. In some embodiments, since the opening O₁ is filled with the insulating layer 130 (i.e., a portion of the insulating layer 106, a portion of the insulting layer 108, a portion of the gate insulating layer 112, a portion of the insulating layer 116, a portion of the dielectric layer 120 and/or a portion of the passivation layer 126 is replaced with a portion of the insulating layer 130) having better ductility, the occurrence of cracking when bending the electronic device 10 can be reduced.

In some embodiments, an organic photoresist material with good fluidity may be coated on the non-bending portion 104a and the bendable portion 104b of the substrate 104 by a spin-on coating process or a slit coating process, then an applicable patterning process (e.g., a lithography process, an etching process, another applicable process, or a combination thereof) may be performed to form the insulating layer 130. In some embodiments, since the organic photoresist material used for forming the insulating layer 130 has good fluidity, it can compensate the height difference of the surfaces of the structure of the layers discussed above to planarize the surface of the structure. Accordingly, the insulating layer 130 may have a substantially planar top surface. In some embodiments, the top surface of the insulating layer 130 may be substantially parallel to the top surface of the substrate 104, but the present disclosure is not limited thereto.

As shown in FIG. 2, the insulating layer 130 on the non-bending portion 104a of the substrate 104 (e.g., the insulating layer 130 on the active layer 110) has a thickness T₁, and the insulating layer 130 on the bendable portion 104b of the substrate 104 has a thickness T₂. In the invention, the thickness T₁ is less than the thickness T₂, but the present disclosure is not limited thereto.

Still referring to FIG. 2, in the invention, the electronic device 10 includes a conductive layer 134 disposed on the insulating layer 130. In the invention, the conductive layer 134 includes conductive lines, conductive pads, other applicable conductive elements, or a combination thereof.

In some embodiments, the electronic device 10 may include one or more conductive vias disposed in the insulating layer 130, and the conductive layer 134 may be electrically connected to the bridging element(s) 128 through the conductive via(s). In some embodiments, the conductive layer 134 is electrically connected to the conductive layer 124 through the bridging element(s) 128.

In some embodiments, the conductive layer 134 may include molybdenum, tungsten, titanium, aluminum, tantalum, platinum, hafnium, copper, another applicable conductive material, or a combination thereof. In some embodiments, the conductive layer 134 may include a stacking structure containing multiple metal layers (e.g., Ti/Al/Ti stacking structure).

In some embodiments, one or more appropriate openings may be formed in the insulating layer 130 by a lithography process, and then a physical vapor deposition process (e.g., a sputtering process or an evaporation process), an electroplating process, another applicable process, or a combination thereof may be used to fill the opening(s) with a conductive material so as to form the conductive layer 134 in the opening(s). For example, the lithography process may include a developing process using a developer. In some embodiments where the bridging elements 128 include the transparent conductive material (e.g., ITO) discussed above, since the transparent conductive material is less susceptible to damage by the developer, the bridging elements 128 can reduce the occurrence of the underlying layers (e.g., the conductive layer 124) being damaged by the developer.

In some embodiments, a physical vapor deposition process (e.g., a sputtering process or an evaporation process), an electroplating process, another applicable process, or a combination thereof may be used to form a conductive blanket layer on the insulating layer 130 and the conductive layer 134 in the openings, and then a patterning process (e.g., a lithography process, an etching process, another applicable process, or a combination thereof) may be performed on the conductive blanket layer to form the patterned conductive layer 134.

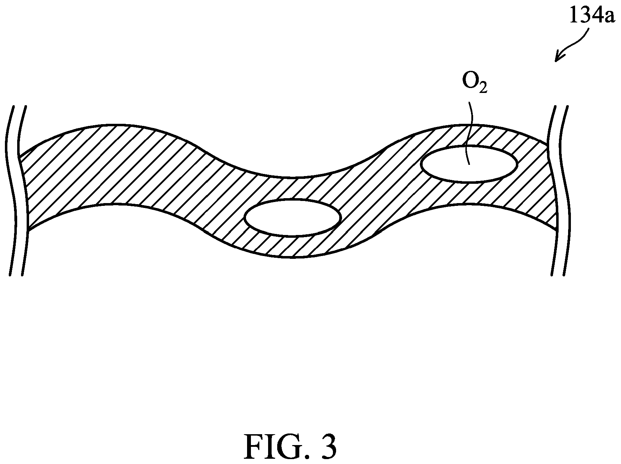

In some embodiments, as shown in FIG. 2 and FIG. 3, the conductive layer 134 includes a conductive line 134a and one or more openings O₂ on the bendable portion 104b. For example, the opening(s) O₂ may be formed in the conductive line 134a of the conductive layer 134, as shown in FIG. 3. In some embodiments, the conductive line 134a has an undulating or wavy edge. In some embodiments, in the top view, at least one of the openings O₂ may fully overlap or partially overlap the opening O₁. In some embodiments, since the conductive line 134a has the undulating edge and/or the opening(s) O₂, the occurrence of the conductive layer 134 cracking when bending the electronic device 10 can be reduced.

For example, the opening(s) O₂ may be formed in the conductive layer 134 by using a patterning process (e.g., a lithography process, an etching process, another applicable process, or a combination thereof). In some embodiments, in the top view, the opening(s) O₂ may be substantially oval, square, rectangular, round, oblong, triangular, polygonal, irregular shape, another applicable shape, or a combination thereof.

Still referring to FIG. 2, in some embodiments, the electronic device 10 may include an insulating layer 136 disposed on the conductive layer 134 and the insulating layer 130. In some embodiments, the opening(s) O₂ may be filled by the insulating layer 136.

In some embodiments, the materials and forming methods of the insulating layer 136 may be the same as or similar to those of the insulating layer 130. In the interest of simplicity and clarity, the details will not be discussed again.

In some embodiments, since the organic photoresist material used for forming the insulating layer 136 has good fluidity, the top surface of the insulating layer 136 can be substantially planar. In some embodiments, the top surface of the insulating layer 136 may be substantially parallel to the top surface of the substrate 104, but the present disclosure is not limited thereto.

As shown in FIG. 2, the insulating layer 136 may have a thickness T₃. For example, the thickness T₃ may be in a range from about 1 µm to about 5 µm, but the present disclosure is not limited thereto.

Still referring to FIG. 2, in some embodiments, the electronic device 10 may include an insulating layer 138. In some embodiments, the insulating layer 138 may extend from the top surface of the insulating layer 136 into the insulating layer 136. In some embodiments, the insulating layer 138 may include silicon nitride, another applicable insulating material, or a combination thereof. In some embodiments, the insulating layer 138 and the insulating layer 136 may include different materials.

For example, the thickness of the insulating layer 138 may be in a range from about 0.1 µm to about 1 µm, but the present disclosure is not limited thereto. In some embodiments, one or more appropriate openings may be formed in the insulating layer 136 by a lithography process, and then the insulating layer 138 may be formed by depositing an insulating material in the opening(s) and on the top surface of the insulating layer 136 by using a chemical vapor deposition process, another applicable process, or a combination thereof.

In some embodiments, after forming the insulating layer 138, a patterning process may be performed on the insulating layer 138 to form a portion of an opening O₃ in the insulating layer 138. In some embodiments, the opening O₃ may be located on the bendable portion 104b. In some embodiments, in the top view, the opening O₃ may fully overlap or partially overlap the opening O₁. In some embodiments, in the top view, the opening O₃ may fully overlap or partially overlap at least one of the openings O₂. In some embodiments, in the top view, the opening O₃ may be substantially oval, square, rectangular, round, oblong, triangular, polygonal, irregular shape, another applicable shape, or a combination thereof. For example, the patterning process may include a lithography process, an etching process, another applicable process, or a combination thereof.

Still referring to FIG. 2, in some embodiments, the electronic device 10 may include a conductive layer 142 disposed on the insulating layer 136. In some embodiments, the conductive layer 142 may include conductive lines, conductive pads, other applicable conductive elements, or a combination thereof. In some embodiments, the conductive layer 142 is electrically connected to the conductive layer 134 through the conductive vias.

In some embodiments, the conductive layer 142 may include molybdenum, tungsten, titanium, aluminum, tantalum, platinum, hafnium, copper, chromium, lead, nickel, zinc, indium, gold, alloys thereof, other applicable conductive materials, or a combination thereof. In some embodiments, the conductive layer 142 may include a stacking structure containing multiple metal layers (e.g., Mo/Cu stacking structure). For example, the thickness of the conductive layer 142 may be in a range from about 0.5 µm to about 5 µm, but the present disclosure is not limited thereto.

In some embodiments, one or more appropriate openings may be formed in the insulating layer 136 by a lithography process, and then a physical vapor deposition process (e.g., a sputtering process or an evaporation process), an electroplating process, another applicable process, or a combination thereof may be used to fill the opening(s) with a conductive material so as to form the conductive layer 142 in the opening(s).

In some embodiments, a physical vapor deposition process (e.g., a sputtering process or an evaporation process), an electroplating process, another applicable process, or a combination thereof may be used to form a conductive blanket layer on the insulating layer 136 and the conductive layer 142 in the opening(s), and then a patterning process (e.g., a lithography process, an etching process, another applicable process, or a combination thereof) may be performed on the conductive blanket layer to form the patterned conductive layer 142.

In some embodiments, the insulating layer 138 disposed between the conductive layer 142 and the insulating layer 136 may serve as an adhesive layer, to reduce peeling of the conductive layer 142 from the insulating layer 136.

Still referring to FIG. 2, in some embodiments, the electronic device 10 may include an insulating layer 144 disposed on the insulating layer 138 and the conductive layer 142. In some embodiments, the top surface of the insulating layer 144 may be substantially planar. In some embodiments, the top surface of the insulating layer 144 may be substantially parallel to the top surface of the substrate 104, but the present disclosure is not limited thereto. In some embodiments, since the top surface of the insulating layer 144 is substantially planar, the conductive pads (e.g., conductive pads 146a and 146b which will be discussed in the following paragraphs) used for connecting the light-emitting unit may be located at substantially the same level. Therefore, the problem of poor bonding between the light-emitting unit and the conductive pads can be alleviated, and thus the yield of the electronic device can be improved.

In some embodiments, the insulating layer 144 may include silicon nitride, silicon oxide, another applicable material, or a combination thereof. In some embodiments, the insulating layer 144 may include a polymer material. In some embodiments, the insulating layer 144 may include an organic photoresist material.

In some embodiments, the insulating layer 144 may be formed by using a chemical vapor deposition process, a thermal oxidation process, another applicable process, or a combination thereof. In some embodiments, the process for forming the insulating layer 144 may include a spin-on coating process, a curing process, another applicable process, or a combination thereof.

In some embodiments, after forming the insulating layer 144, a patterning process may be performed on the insulating layer 144 to form a portion of the opening O₃ in the insulating layer 144. In some embodiments, the portion of the opening O₃ in the insulating layer 144 is in communication with the portion of the opening O₃ in the insulating layer 138. For example, the patterning process may include a lithography process, an etching process, another applicable process, or a combination thereof.

Still referring to FIG. 2, in some embodiments, the electronic device 10 may include a conductive pad 146a and a conductive pad 146b. In some embodiments, at least a portion of the insulating layer 144 is located between the conductive pads (e.g., the conductive pad 146a and the conductive pad 146b). In some embodiments, the conductive pad 146a and the conductive pad 146b may be located at substantially the same level, thus reducing the problem of the poor bonding between the light-emitting unit (e.g., light-emitting unit 150 which will be discussed in the following paragraphs) and the conductive pads (e.g., conductive pads 146a and 146b) and improving the yield of the electronic device. In some embodiments, the top surface of the conductive pad 146a and the top surface of the conductive pad 146b may be located at substantially the same level. In some embodiments, the top surface of the conductive pad 146a and the top surface of the conductive pad 146b may be coplanar.

In some embodiments, the conductive pad 146a and the conductive pad 146b may extend from the top surface of the insulating layer 144 into the insulating layer 144. In some embodiments, the conductive pad 146a and the conductive pad 146b may include molybdenum, tungsten, titanium, aluminum, tantalum, platinum, hafnium, copper, chromium, lead, nickel, zinc, indium, gold, alloys thereof, other applicable conductive materials, or a combination thereof. In some embodiments, the conductive pad 146a and the conductive pad 146b may include a stacking structure containing multiple metal layers (e.g., a Ni/Au stacking structure). In some embodiments, the outermost layer of the conductive pad 146a and the conductive pad 146b may be an antioxidation layer including a metal with good oxidation resistance (e.g., Pt, Au, Pd, or a combination thereof), but the present disclosure is not limited thereto.

In some embodiments, a patterning process (e.g., a lithography process, an etching process, another applicable process, or a combination thereof) may be performed to form appropriate openings in the insulating layer 144, then a physical vapor deposition process, an electroplating process, an electroless plating process, another applicable process, or a combination thereof may be applied to deposit a conductive material in the openings and on the top surface of the insulating layer 144 to form the conductive pad 146a and the conductive pad 146b.

Still referring to FIG. 2, in some embodiments, the electronic device 10 includes a light-emitting unit 150 connected to the conductive pad 146a and the conductive pad 146b. In some embodiments, the light-emitting unit 150 may include a light-emitting diode (e.g., a blue light-emitting diode, a red light-emitting diode, or a green light-emitting diode), an organic light-emitting diode, a micro light-emitting diode, a quantum-dot light-emitting diode, a mini light-emitting diode, another applicable light-emitting unit, or a combination thereof.

In some embodiments, the light-emitting unit 150 may be electrically connected to the source/drain regions 110a of the active layer 110 through the conductive pads 146a and 146b, the conductive layer 142, the conductive layer 134, and the conductive layer 124.

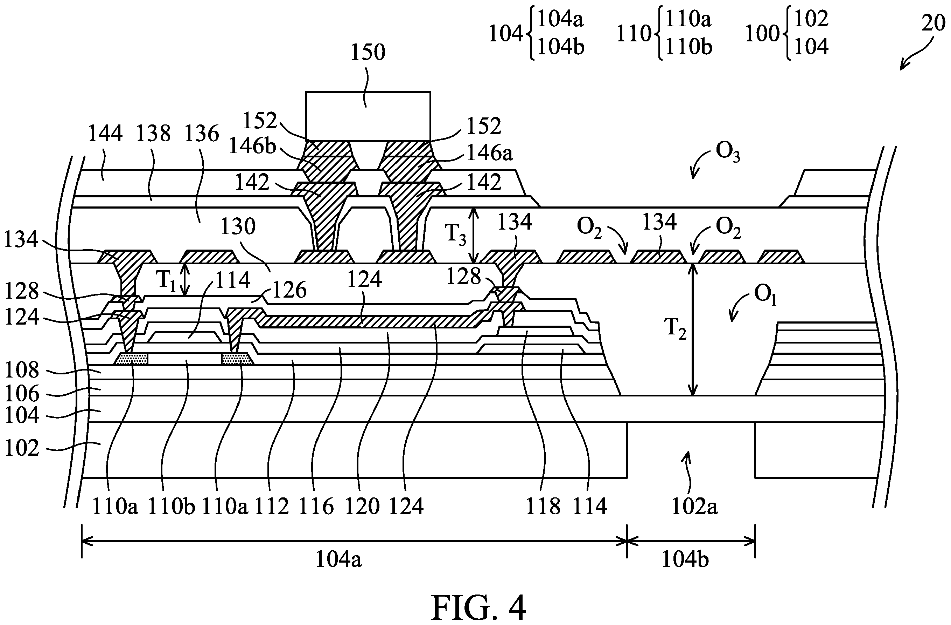

FIG. 4 illustrates an electronic device (e.g., a display device) 20 according to some embodiments of the present disclosure. One difference between the electronic device 10 and the electronic device 20 is that the light-emitting unit 150 and the active layer 110 of the electronic device 20 are laterally spaced apart from each other. In some embodiments, the active layer 110 and the light emitting unit 150 do not overlap in the normal direction, and the normal direction may refer to a direction that is perpendicular to the top surface of the substrate 104 in the present disclosure. In some embodiments, since the light-emitting unit 150 and the active layer 110 of the electronic device 20 are laterally spaced apart from each other, occurrences of the active layer 110 being crushed by the light-emitting unit 150 when bonding the light-emitting unit 150 to the conductive pads 146a and 146b can be reduced.

In some embodiments, the light-emitting unit 150 may include a main portion (e.g., light-emitting chip(s) C1 which will be discussed in the following paragraphs) and a connection feature. In some embodiments, the main portion of the light-emitting unit 150 may include gallium nitride, aluminum gallium nitride, aluminum nitride, gallium arsenide, indium gallium phosphide, aluminum gallium arsenide, indium phosphide, indium aluminum arsenide, indium gallium arsenide, aluminum gallium indium phosphide, another applicable semiconductor material, or a combination thereof, but the present disclosure is not limited thereto.

The light-emitting unit 150 may be electrically connected to the conductive pads 146a and 146b through its connection feature. In other words, the light-emitting unit 150 may be electrically connected to the thin-film transistor through its connection feature. In some embodiments, the connection feature of the light-emitting unit 150 may include conductive wiring layers, conductive pads, electrodes, bumps, other applicable connection features, or a combination thereof. For example, the connection feature of the light-emitting unit 150 may include a metal (e.g., copper, tungsten, silver, tin, nickel, chromium, titanium, lead, gold, bismuth, antimony, zinc, zirconium, magnesium, indium, tellurium, gallium, or another applicable metal), an alloy thereof, another applicable conductive material, or a combination thereof, but the present disclosure is not limited thereto.

In some embodiments, the light-emitting unit 150 may be electrically connected to the conductive pads 146a and 146b through a conductive medium 152. In some embodiments, the conductive medium 152 overlaps the conductive pads 146a and 146b in the normal direction. In some embodiments, the conductive medium 152 is in direct contact with the conductive pads 146a and 146b and with the connection feature of the light-emitting unit 150. For example, the conductive medium 152 may include tin, tin alloy, conductive glue (e.g., anisotropic conductive film), another applicable material, or a combination thereof. In some embodiments, the process for bonding the light-emitting unit 150 to the conductive pad 146a and the conductive pad 146b may include a soldering process, but the present disclosure is not limited thereto.

In some embodiments, there is no conductive medium 152 disposed between the light-emitting unit 150 and the conductive pad (e.g., the conductive pads 146a and 146b), and the connection feature of the light-emitting unit 150 may be in direct contact with the conductive pad (e.g., the conductive pads 146a and 146b). In these embodiments, a eutectic bonding process may be performed to cause a eutectic reaction between the connection feature of the light-emitting unit 150 and the conductive pad (e.g., the conductive pads 146a and 146b), so as to bond the light-emitting unit 150 to the conductive pad (e.g., the conductive pads 146a and 146b).

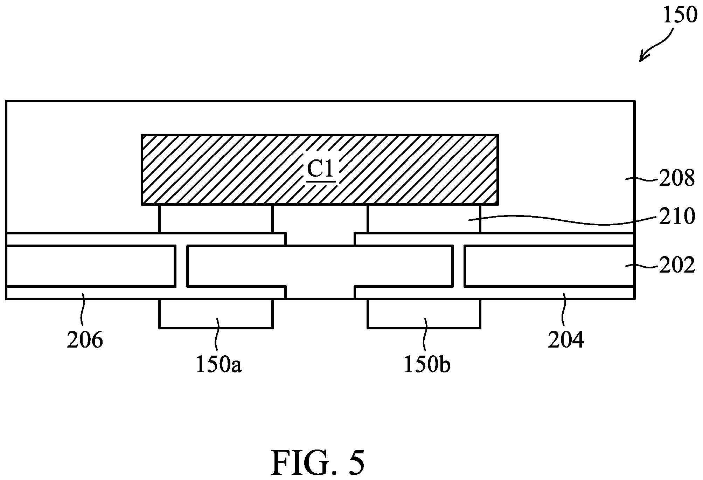

FIG. 5 illustrates a cross-sectional view of the light-emitting unit 150 according to some embodiments of the present disclosure. In some embodiments, as shown in FIG. 5, the light-emitting unit 150 may include a packaging substrate 202, the packaging substrate 202 may be a flat plate, and conductive wiring layers 204 and 206 may be disposed on the surfaces of the packaging substrate 202 and in the packaging substrate 202. In some embodiments, the light-emitting unit 150 has a light-emitting chip (e.g., a light-emitting diode chip) C1, the light-emitting chip C1 is disposed on the packaging substrate 202 with its conductive end facing downward, and the light-emitting chip C1 may be electrically connected to the conductive wiring layers 204 and 206 of the surfaces of the packaging substrate 202 through bonding pads 210 or another applicable material such as solder balls. In some embodiments, the light-emitting unit 150 may be electrically connected to the conductive pads 146a and 146b directly through the conductive wiring layers 204 and 206 thereof. In some embodiments, the light-emitting unit 150 may further include conductive pads 150a and 150b disposed under the conductive wiring layers 204 and 206, and the light-emitting unit 150 may be electrically connected to the conductive pads 146a and 146b through the conductive wiring layers 204 and 206 and the conductive pads 150a and 150b. Each or the whole of the conductive wiring layer 204, the conductive wiring layer 206, the bonding pads 210, the conductive pad 150a, and the conductive pad 150b may be considered as the connection feature of the light-emitting unit 150. In some embodiments, the packaging substrate 202 including the conductive wiring layers 204 and 206 may serve as a support structure for supporting the light-emitting chip C1.

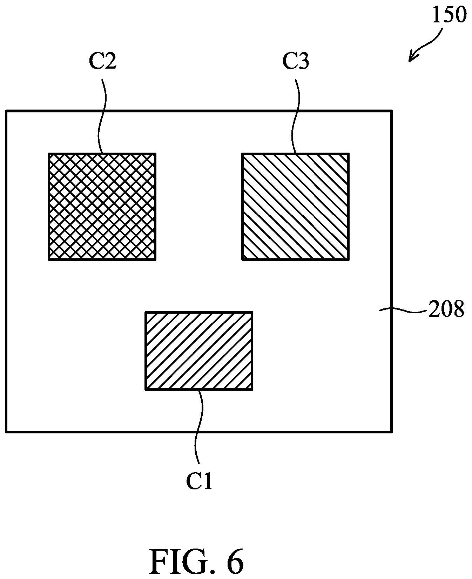

It should be noted that although the light-emitting unit 150 of the embodiments illustrated in FIG. 5 has only one light-emitting chip C1, the present disclosure is not limited thereto. In some other embodiments, the light-emitting unit 150 may include a plurality of light-emitting chips. For example, as shown in FIG. 6, the light-emitting unit 150 may have a light-emitting chip C1, a light-emitting chip C2, and a light-emitting chip C3. The light-emitting chip C1, the light-emitting chip C2, and the light-emitting chip C3 may respectively emit a red light, a green light, and a blue light. In some embodiments, the light-emitting unit 150 may also include encapsulating glue 208, and the encapsulating glue 208 may be disposed on the light-emitting chip (e.g., the light-emitting chip C1, the light-emitting chip C2, and the light-emitting chip C3) and the packaging substrate 202. In some embodiments, the encapsulating glue 208 may be disposed on the light-emitting side of the light-emitting chip. For example, the material of the encapsulating glue 208 may be epoxy based resin or silicone, but the present disclosure is not limited thereto. In some embodiments, a plurality of light-emitting units 150 are disposed on the composite substrate 100 of the electronic device 10. In some embodiments, the plurality of light-emitting units 150 on the composite substrate 100 are separate from each other, and thus the packaging substrate 202 and the encapsulating glue 208 of a first light-emitting unit 150 are not in direct contact with the packaging substrate 202 and the encapsulating glue 208 of a second light-emitting unit 150 adjacent to the first light-emitting unit 150. In some embodiments, respective encapsulating glue may be disposed respectively on light-emitting chip C1, C2 or C3.

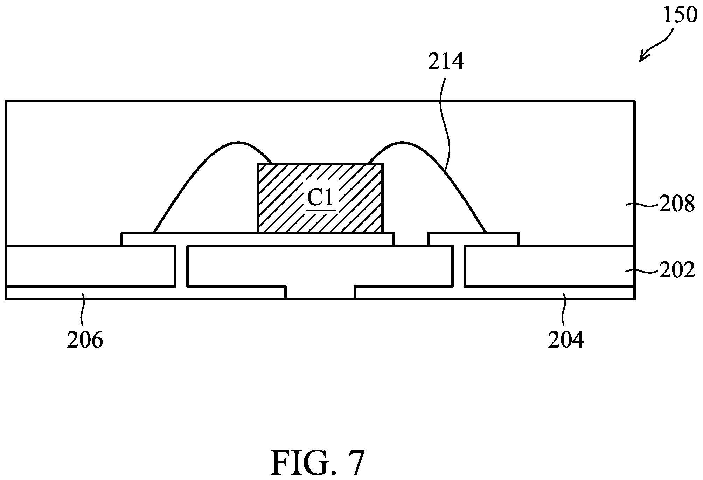

FIGS. 7 to 10 illustrate some variant embodiments of the light-emitting unit 150 of the present disclosure. It should be noted that unless otherwise specified, in these variant embodiments, the elements and layers the same as or similar to those discussed in the above embodiments will be denoted by the same reference numerals, and the materials and forming methods thereof may also be the same as or similar to those discussed in the above embodiments. In addition, although only one light-emitting chip is illustrated in FIGS. 7 to 9 for discussion, the number of light-emitting chips packaged in the light-emitting unit 150 is not limited thereto. Further, the light-emitting unit 150 may have any suitable number of light-emitting chips packaged by the encapsulating glue 208 according to the design requirement.

FIG. 7 illustrates a variant embodiment of the light-emitting unit 150 of the present disclosure. One difference between the light-emitting unit 150 of the embodiment illustrated in FIG. 7 and the light-emitting unit 150 of the embodiments illustrated in FIG. 5 is that the light-emitting chip C1 of the light-emitting unit 150 of the embodiment illustrated in FIG. 7 is disposed on the surface of the packaging substrate 202 with its conductive end facing upward. In the embodiment illustrated in FIG. 7, the conductive end (not shown in the figures) of the surface of the light-emitting chip C1 may be electrically connected to the conductive wiring layer 204 and the conductive wiring layer 206 of the surfaces of the packaging substrate 202 through conductive wires 214. In FIG. 7, each or the whole of the conductive wiring layer 204, the conductive wiring layer 206, and the conductive wires 214 may be considered as the connection feature of the light-emitting unit 150.

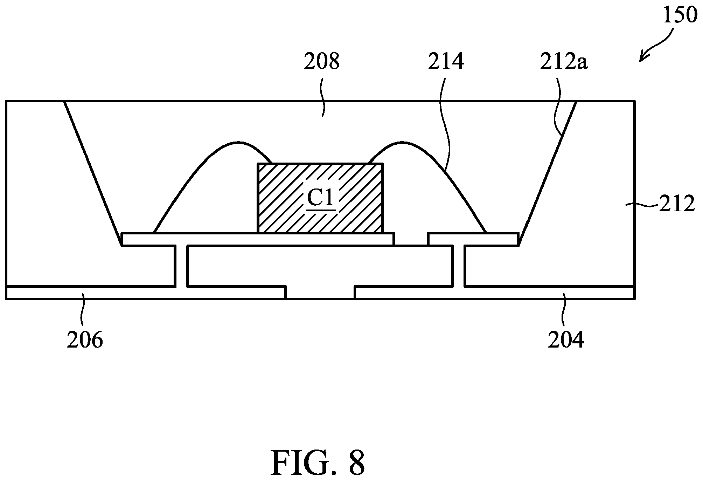

FIG. 8 illustrates a variant embodiment of the light-emitting unit 150 of the present disclosure. In the embodiment illustrated in FIG. 8, a packaging substrate 212 has a sidewall 212a and thus forms a cup-shaped structure surrounding the light-emitting chip C1. In the light-emitting unit 150, the light-emitting chip C1 may be disposed in the chamber or recess of the packaging substrate 212, and the light-emitting chip C1 may be electrically connected to the conductive wiring layers 204 and 206 disposed in the packaging substrate 212 through the conductive wires 214. In addition, the encapsulating glue 208 may be disposed in the chamber or recess of the packaging substrate 212 to overlie and protect the light-emitting chip C1. The packaging substrate of the embodiments illustrated in FIG. 7 and FIG. 8 may have high reflectivity to improve the light utilization efficiency. In some embodiments, the packaging substrate 212 including the conductive wiring layers 204 and 206 may serve as a support structure for supporting the light-emitting chip C1. In FIG. 8, each or the whole of the conductive wiring layer 204, the conductive wiring layer 206, and the conductive wires 214 may be considered as the connection feature of the light-emitting unit 150.

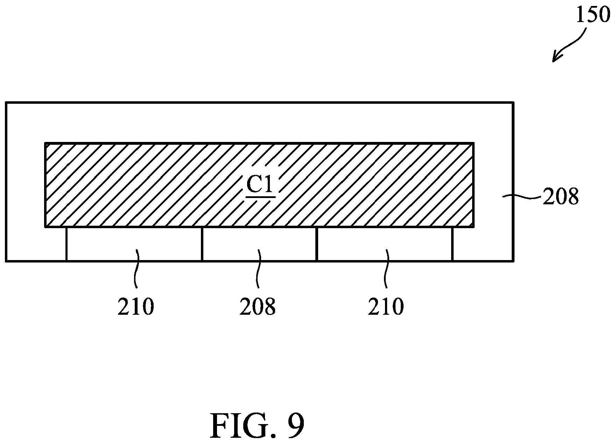

FIG. 9 illustrates a variant embodiment of the light-emitting unit 150 of the present disclosure. In the embodiment illustrated in FIG. 9, the light-emitting chip C1 is packaged with its conductive end facing downward, and the encapsulating glue 208 is disposed on the light-emitting chip C1 to form the light-emitting unit 150. In some embodiments, the bonding pads 210 are exposed by the encapsulating glue 208, and thus the light-emitting chip C1 can be electrically connected to the conductive pads 146a and 146b directly through the bonding pads 210 without using the cup-shaped support or the packaging substrate 202 of the above embodiments. In some embodiments, the bonding pads 210 are in direct contact with the conductive pads 146a and 146b. In FIG. 9, each or all of the bonding pads 210 can be considered as the connection feature of the light-emitting unit 150.

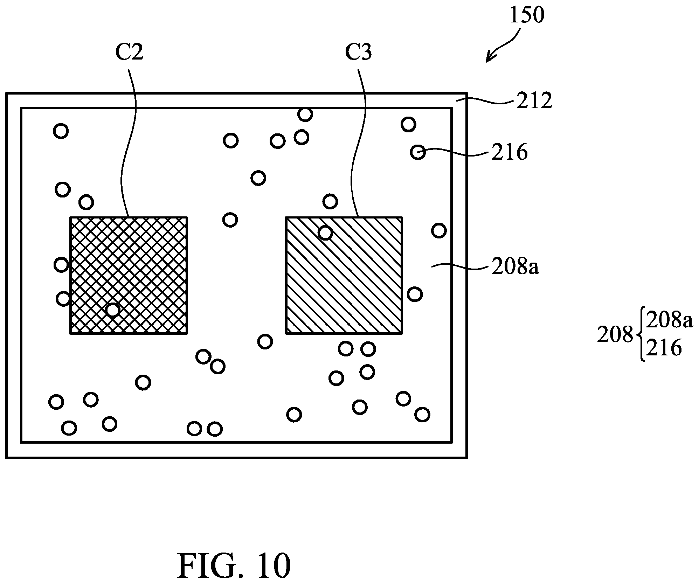

FIG. 10 illustrates a top plan view showing a variant embodiment of the light-emitting unit 150 of the present disclosure. In the embodiment illustrated in FIG. 10, the light-emitting unit 150 includes two light-emitting chips C2 and C3. In some embodiments, the color of the light emitted by the light-emitting chip C2 is different from the color of the light emitted by the light-emitting chip C3. For example, the light-emitting chip C2 may emit blue light, and the light-emitting chip C3 may emit green light. In some embodiments, the encapsulating glue 208 of the light-emitting unit 150 may include an encapsulating material (e.g., epoxy based resin or silicone) 208a and phosphor powders (e.g., red phosphor powders) 216 dispersed in the encapsulating material 208a. When the blue light and/or the green light emitted by the light-emitting chips irradiate the phosphor powders 216, part of the blue light and/or the green light may be converted into red light, and thus the light-emitting unit 150 can generate white light by mixing the green light, the blue light, and the red light. In some other embodiments, the light-emitting unit 150 of the present disclosure only has a blue light-emitting chip, and the encapsulating glue 208 includes yellow phosphor powders therein, and thus the light-emitting unit 150 can generate white light. In some other embodiments, the light-emitting unit 150 of the present disclosure only has a blue light-emitting chip, and the encapsulating glue 208 includes quantum dots with different diameters, and thus the light-emitting unit 150 can generate lights of different colors. In some other embodiments, quantum dots may be disposed on the light-emitting chip of the light-emitting unit 150 of the present disclosure. In some other embodiments, the encapsulating glue 208 of the light-emitting unit 150 of the present disclosure may include light-diffusing particles therein to improve the brightness uniformity when emitting the light. The light-emitting units 150 with different encapsulating glues discussed above, or other applicable light-emitting units, may be applied in the embodiments and variant embodiments of the present disclosure. Further details will not be discussed herein.

It should be understood that other elements (e.g., a cover plate or an optical film) may be formed on the electronic device 10 in some embodiments, although they are not shown in FIG. 2. For example, the cover plate may include glass, indium tin oxide, polyimide, polyethylene terephthalate, another applicable material, or a combination thereof, but the present disclosure is not limited thereto. For example, the optical film may include a diffuser film, a condenser lens, another applicable optical film, or a combination thereof, but the present disclosure is not limited thereto.

It should be understood that only one light-emitting unit 150 of the electronic device 10 is illustrated in FIG. 2 for convenience of explanation. However, the electronic device 10 can include any suitable number of light-emitting units 150. In some embodiments, these light-emitting units 150 have corresponding encapsulating glues 208, and some of the corresponding encapsulating glues 208 are separated from each other. In some other embodiments, these light-emitting units 150 have corresponding packaging substrates 202, and some of the corresponding packaging substrates 202 are separated from each other, but the encapsulating glues 208 are connected to each other.

It should be understood that the electronic device 10 (e.g., a display device) may be bent to form a curved electronic device (e.g., a curved display device) in some embodiments. The curved electronic devices in these embodiments may include technical features the same as or similar to those of the electronic device 10, and they should be included in the scope of the present disclosure.

It should be understood that an electronic device (e.g., a display device) with a big size may be formed by assembling a plurality of the electronic devices (e.g., a display device) 10 in some embodiments, and it should be included in the scope of the present disclosure.

It should be understood that the composite substrate 100, and the layers and elements on the composite substrate 100 of the electronic device 10 may serve as a back light unit or back light module.

In summary, an insulating layer with a good ductility may be disposed on the substrate of the electronic device of the present disclosure, thus reducing the occurrence of cracking when bending the electronic device. In addition, in some embodiments, a substantially planar insulating layer may be disposed between the light-emitting unit and the substrate of the electronic device, so that the conductive pads used for connecting the light-emitting unit can be located at substantially the same level, thus reducing the occurrence of the poor bonding between the light-emitting unit and the conductive pads and improving the yield of the electronic device.

The foregoing outlines features of several embodiments so that those skilled in the art may better understand the aspects of the present disclosure. The invention is defined by the appended claims.

## Claims

1. An electronic device (10), comprising:
a substrate (104) comprising a bendable portion (104b) and a non-bending portion (104a) adjacent to the bendable portion;
a plurality of thin-film transistors disposed on the non-bending portion (104a) of the substrate (104);
a first insulating layer (130) disposed on the plurality of thin-film transistors; and
a plurality of light-emitting units (150), and one of the plurality of light-emitting units is electrically connected to at least one of the plurality of thin-film transistors; and
a conductive line (134a) disposed on the bendable portion,
wherein a thickness of the first insulating layer (130) on the non-bending portion is less than a thickness of the first insulating layer on the bendable portion and and **characterized in that** the conductive line has an undulating edge or at least one opening (O2).

2. The electronic device (10) as claimed in claim 1, wherein the light-emitting unit further (150) has a connection feature, and the light-emitting unit (150) is electrically connected to the thin-film transistor through the connection feature.

3. The electronic device (10) as claimed in claim 1, wherein the light-emitting unit (150) further has a first light-emitting chip (C1) and a packaging substrate (212), and the first light-emitting chip (C1) is disposed on the packaging substrate.

4. The electronic device (10) as claimed in claim 3, wherein, the packaging substrate (212) has a sidewall (212a) surrounding the first light-emitting chip (C1).

5. The electronic device (10) as claimed in claim 3, further comprising an encapsulating glue (208) disposed on the first light-emitting chip (C1), wherein the encapsulating glue (208) comprises an encapsulating material (208a), and phosphor powders, quantum dots, or light-diffusing particles distributed in the encapsulating material.

6. The electronic device (10) as claimed in one of the preceding claims, further comprising:
a second insulating layer (136) disposed on the first insulating layer (130); and
a plurality of conductive pads (146a, 146b) disposed on the second insulating layer, wherein one of the plurality of conductive pads is electrically connected to one of the plurality of thin-film transistors through a conductive layer (142) penetrating the second insulating layer, wherein the electronic device further comprising:
a conductive medium (152) electrically connected to the light-emitting unit and the conductive pads; wherein the conductive medium (152) overlaps the conductive pads in a normal direction of the substrate.

7. The electronic device (10) as claimed in one of the preceding claims, wherein the first insulating layer (130) comprises an organic photoresist material; and/or
wherein the first insulating layer (130) is in direct contact with a bendable portion of the substrate.

8. The electronic device (10) as claimed in one of the preceding claims, wherein the thin-film transistor has an active layer (110), and the active layer does not overlap the light-emitting unit (150) in a normal direction of the substrate.

9. The electronic device (10) as claimed in claim 3, wherein the light-emitting unit (150) comprises the first light-emitting chip (C1) of a first color, and a second light-emitting chip (C2) of a second color different from the first color.

10. The electronic device (10) as claimed in one of the preceding claims, further comprising:
a third insulating layer (144) disposed on the plurality of thin-film transistors;
wherein at least a portion of the third insulating layer is disposed between the conductive pads, and the light-emitting unit (150) is electrically connected to the thin-film transistor through the conductive pads.

11. The electronic device (10) as claimed in claim 10, wherein the conductive pads (146a, 146b) extend into the third insulating layer (144).

12. The electronic device (10) as claimed in one of the preceding claims, further comprising a composite substrate, wherein the composite substrate includes a sub-layer (102) and the substrate, wherein a ductility of the substrate (104) is greater than a ductility of the sub-layer (102).

13. The electronic device (10) as claimed in claim 12, wherein the sub-layer (102) includes an opening (102a) to expose the substrate.

## Patentansprüche

1. ElektronischeVorrichtung (10), umfassend:
ein Substrat (104), das einen biegbaren Abschnitt (104b) und einen an den biegbaren Abschnitt angrenzenden nicht biegbaren Abschnitt (104a) umfasst;
eine Vielzahl von Dünnschichttransistoren, die auf dem nicht gebogenen Abschnitt (104a) des Substrats (104) angeordnet sind;
eine erste Isolierschicht (130), die auf der Vielzahl von Dünnschichttransistoren angeordnet ist; und
eine Vielzahl von lichtemittierenden Einheiten (150), wobei eine der Vielzahl von lichtemittierenden Einheiten elektrisch mit mindestens einem der Vielzahl von Dünnschichttransistoren verbunden ist; und
eine leitende Leitung (134a), die auf dem biegbaren Abschnitt angeordnet ist,
wobei eine Dicke der ersten Isolierschicht (130) auf dem nicht biegbaren Abschnitt geringer ist als eine Dicke der ersten Isolierschicht auf dem biegbaren Abschnitt und **dadurch gekennzeichnet ist, dass** die leitende Linie eine wellenförmige Kante oder mindestens eine Öffnung (O2) aufweist.

2. Elektronische Vorrichtung (10) nach Anspruch 1, wobei die lichtemittierende Einheit (150) ferner ein Verbindungsmerkmal aufweist und die lichtemittierende Einheit (150) über das Verbindungsmerkmal elektrisch mit dem Dünnschichttransistor verbunden ist.

3. Elektronische Vorrichtung (10) nach Anspruch 1, wobei die lichtemittierende Einheit (150) ferner einen ersten lichtemittierenden Chip (C1) und ein Verpackungssubstrat (212) aufweist, und der erste lichtemittierende Chip (C1) auf dem Verpackungssubstrat angeordnet ist.

4. Elektronische Vorrichtung (10) nach Anspruch 3, wobei das Verpackungssubstrat (212) eine Seitenwand (212a) aufweist, die den ersten lichtemittierenden Chip (C1) umgibt.

5. Elektronische Vorrichtung (10) nach Anspruch 3 , ferner umfassend einen einkapselnden Klebstoff (208), der auf dem ersten lichtemittierenden Chip (C1) angeordnet ist, wobei der einkapselnde Klebstoff (208) ein einkapselndes Material (208a) und in dem einkapselnden Material verteilte Leuchtstoffpulver, Quantenpunkte oder lichtstreuende Teilchen aufweist.

6. Elektronische Vorrichtung (10) nach einem der vorhergehenden Ansprüche, ferner umfassend:
eine zweite Isolierschicht (136), die auf der ersten Isolierschicht (130) angeordnet ist; und
eine Vielzahl von leitenden Anschlussflächen (146a, 146b), die auf der zweiten Isolierschicht angeordnet sind, wobei eine der Vielzahl von leitenden Anschlussflächen mit einem der Vielzahl von Dünnschichttransistoren durch eine leitende Schicht (142), die die zweite Isolierschicht durchdringt, elektrisch verbunden ist, wobei die elektronische Vorrichtung ferner umfasst:
ein leitendes Medium (152), das elektrisch mit der lichtemittierenden Einheit und den leitenden Anschlussflächen verbunden ist; wobei das leitende Medium (152) die leitenden Anschlussflächen in einer normalen Richtung des Substrats überlappt.

7. Elektronische Vorrichtung (10) nach einem der vorhergehenden Ansprüche, wobei die erste Isolierschicht (130) ein organisches Photoresistmaterial umfasst; und/oder
wobei die erste Isolierschicht (130) in direktem Kontakt mit einem biegbaren Abschnitt des Substrats steht.

8. Elektronische Vorrichtung (10) nach einem der vorhergehenden Ansprüche, wobei der Dünnschichttransistor eine aktive Schicht (110) aufweist und die aktive Schicht die lichtemittierende Einheit (150) in einer normalen Richtung des Substrats nicht überlappt.

9. Elektronische Vorrichtung (10) nach Anspruch 3, wobei die lichtemittierende Einheit (150) den ersten lichtemittierenden Chip (C1) mit einer ersten Farbe und einen zweiten lichtemittierenden Chip (C2) mit einer zweiten, von der ersten Farbe verschiedenen Farbe umfasst.

10. Elektronische Vorrichtung (10) nach einem der vorhergehenden Ansprüche, ferner umfassend:
eine dritte Isolierschicht (144), die auf der Vielzahl von Dünnschichttransistoren angeordnet ist;
wobei mindestens ein Abschnitt der dritten Isolierschicht zwischen den leitenden Anschlussflächen angeordnet ist und die lichtemittierende Einheit (150) über die leitenden Anschlussflächen elektrisch mit dem Dünnschichttransistor verbunden ist.

11. Elektronische Vorrichtung (10) nach Anspruch 10, wobei sich die leitenden Anschlussflächen (146a, 146b) in die dritte Isolierschicht (144) erstrecken.

12. Elektronisches Bauelement (10) nach einem der vorhergehenden Ansprüche, ferner umfassend ein Verbundsubstrat, wobei das Verbundsubstrat eine Unterschicht (102) und das Substrat umfasst, wobei eine Duktilität des Substrats (104) größer ist als eine Duktilität der Unterschicht (102).

13. Elektronische Vorrichtung (10) nach Anspruch 12, wobei die Unterschicht (102) eine Öffnung (102a) aufweist, um das Substrat freizulegen.

## Revendications

1. Dispositif électronique (10) comprenant :
un substrat (104) comprenant une partie pliable (104b) et une partie non pliable (104a) adjacente à la partie pliable ;
une pluralité de transistors à couches minces disposés sur la partie non pliable (104a) du substrat (104) ;
une première couche isolante (130) disposée sur la pluralité de transistors à couches minces ; et
une pluralité d'unités d'émission de lumière (150), l'une de ladite pluralité d'unités d'émission de lumière étant connectée électriquement à au moins l'un de ladite pluralité de transistors à couches minces; et
une ligne conductrice (134a) disposée sur la partie pliable,
dans lequel une épaisseur de la première couche isolante (130) sur la partie non pliable est inférieure à une épaisseur de la première couche isolante sur la partie pliable, et **caractérisé en ce que** la ligne conductrice comprend un bord ondulé ou au moins une ouverture (O2).

2. Dispositif électronique (10) selon la revendication 1, dans lequel l'unité émettrice de lumière (150) comprend en outre une caractéristique de connexion et l'unité émettrice de lumière (150) est connectée électriquement au transistor à couche mince par l'intermédiaire de la caractéristique de connexion.

3. Dispositif électronique (10) selon la revendication 1, dans lequel l'unité émettrice de lumière (150) comprend en outre une première puce émettrice de lumière (C1) et un substrat de conditionnement (212), et la première puce émettrice de lumière (C1) est disposée sur le substrat de conditionnement.

4. Dispositif électronique (10) selon la revendication 3, dans lequel le substrat de conditionnement (212) comprend une paroi latérale (212a) entourant la première puce émettrice de lumière (C1).

5. Dispositif électronique (10) selon la revendication 3, comprenant en outre un adhésif d'encapsulation (208) disposé sur la première puce émettrice de lumière (C1), l'adhésif d'encapsulation (208) comprenant un matériau d'encapsulation (208a) et des poudres fluorescentes, des points quantiques ou des particules diffusant la lumière dispersés dans le matériau d'encapsulation.

6. Dispositif électronique (10) selon l'une quelconque des revendications précédentes, comprenant en outre:
une deuxième couche isolante (136) disposée sur la première couche isolante (130); et
une pluralité de plots conducteurs (146a, 146b) disposés sur la seconde couche isolante, l'un de la pluralité de plots conducteurs étant connecté électriquement à l'un de la pluralité de transistors à couches minces par une couche conductrice (142) pénétrant dans la seconde couche isolante, le dispositif électronique comprenant en outre:
un milieu conducteur (152) connecté électriquement à l'unité émettrice de lumière et aux plots conducteurs; dans lequel le milieu conducteur (152) chevauche les plots conducteurs dans une direction normale du substrat.

7. Dispositif électronique (10) selon l'une quelconque des revendications précédentes, dans lequel la première couche isolante (130) comprend un matériau photorésistant organique; et/ou
dans lequel la première couche isolante (130) est en contact direct avec une partie pliable du substrat.

8. Dispositif électronique (10) selon l'une quelconque des revendications précédentes, dans lequel le transistor à couches minces comprend une couche active (110), la couche active ne chevauchant pas l'unité émettrice de lumière (150) dans une direction normale du substrat.

9. Dispositif électronique (10) selon la revendication 3, dans lequel l'unité émettrice de lumière (150) comprend la première puce émettrice de lumière (C1) ayant une première couleur et une deuxième puce émettrice de lumière (C2) ayant une deuxième couleur différente de la première couleur.

10. Dispositif électronique (10) selon l'une quelconque des revendications précédentes, comprenant en outre:
une troisième couche isolante (144) disposée sur la pluralité de transistors à couches minces;
dans lequel au moins une partie de la troisième couche isolante est disposée entre les plages de connexion conductrices, et l'unité émettrice de lumière (150) est connectée électriquement au transistor à couche mince par l'intermédiaire des plages de connexion conductrices.

11. Dispositif électronique (10) selon la revendication 10, dans lequel les plages de connexion conductrices (146a, 146b) s'étendent dans la troisième couche isolante (144).

12. Dispositif électronique (10) selon l'une quelconque des revendications précédentes, comprenant en outre un substrat composite, le substrat composite comprenant une sous-couche (102) et le substrat, dans lequel une ductilité du substrat (104) est supérieure à une ductilité de la sous-couche (102).

13. Dispositif électronique (10) selon la revendication 12, dans lequel la sous-couche (102) comporte une ouverture (102a) permettant d'exposer le substrat.
